# EUROPEAN PATENT APPLICATION

(11) **EP 2 876 695 A1**
(43) Date of publication of application: **27.05.2015**
(21) Application number: 14193971.0
(22) Date of filing: 20.11.2014
(51) Int. Cl.: H01L 31/0749, H01L 31/046, H01L 31/0468

(54) **Solar cell**

(30) Priority: 20.11.2013 KR 20130141705
(71) Applicant: Samsung SDI Co., Ltd., Yongin-si, Gyeonggi-do (KR)
(72) Inventor: Kim, Dong-Jin, Gyeonggi-do (KR)
(74) Representative: Mounteney, Simon James

(57) **Abstract**

Disclosed herein is a solar cell, the solar cell includes a substrate, a plurality of first electrodes formed on the substrate and separated into a plurality of first separation grooves, a buffer layer and an optical active layer formed on the first electrode and having a through groove exposing the first electrode adjacent thereto, and a plurality of second electrodes formed on the optical active layer, separated into a plurality of second separation grooves, and electrically connected to the first electrode through the through groove, wherein the first electrode or the second electrode is divided by a plurality of third separation groove formed in a direction intersecting with the first separation groove, the through groove, and the second separation groove.

## Description

### BACKGROUND

### 1. Field

The present invention relates generally to a solar cell.

### 2. Description of the Related Art

A solar cell, which is a photovoltaic device that converts solar energy into electrical energy, is a next-generation pollution free energy source.

A solar cell typically includes p-type semiconductor and n-type semiconductor. When solar energy is absorbed at an optical active layer, an electron-hole pair (EHP) is generated in the semiconductor, wherein the generated electron and hole move to the n-type semiconductor and the p-type semiconductor, respectively, and are collected by electrodes, electrical energy can be generated.

As the optical active layer, a compound semiconductor containing group I-III-VI elements may be used. The compound semiconductor may provide a high efficiency solar cell with a high light absorption coefficient and high optical stability.

Some solar cells are made of unit cells of the same size which are electrically connected to each other on a substrate, and the unit cells may be separated through a scribing process and a patterning process such as laser irradiation after forming in a thin film over the entire surface of the substrate.

In order to form the solar cell, a first patterning process of separating a lower electrode, a second patterning process of separating the optical active layer and a third patterning process of separating an upper electrode are performed. In this case, a length of the thin film separating at the time patterning process as a size of the substrate is increased, and it is difficult to adjust a constant depth of a separation groove, such that a pattern defect may occur. Accordingly, the efficiency of the solar cell may be degraded if the pattern is defective.

The above information disclosed in this Background section is only for enhancement of understanding of the background of the described technology and therefore it may contain information that does not form the prior art that is already known in this country to a person of ordinary skill in the art.

### SUMMARY

The present invention has been made to solve the above problem and to provide a solar cell capable of minimizing the efficiency loss due to an error in pattern even if a size of solar cell is increased.

An embodiment of the invention provides a solar cell including: a substrate; a plurality of first electrodes formed on the substrate and separated into a plurality of first separation grooves; a buffer layer and an optical active layer formed on the first electrode and having a through groove exposing the first electrode adjacent thereto; and a plurality of second electrodes formed on the optical active layer, separated into a plurality of second separation grooves, and electrically connected to the first electrode through the through groove, wherein the first electrode or the second electrode is divided by a plurality of third separation groove formed in a direction intersecting with the first separation groove, the through groove, and the second separation groove.

The first separation groove, the through groove, and the second separation groove may be disposed in the order of the first separation groove, the through groove, and the second separation groove to form one of separation group, and the separation group may be repeatedly disposed at predetermined interval.

The third separation groove may be connected to the second separation groove adjacent thereto.

The third separation grooves disposed at both sides, having the second separation groove disposed therebetween may be disposed to be shifted from each other.

Each of the first electrode, optical active layer, buffer layer and second electrode divided by the separation group forms the power generating part, and each of the second electrodes of the power generating part may be divided in plural by the third separation groove.

The third separation groove may be connected to the first separation grove adjacent thereto.

The third separation grooves disposed at both sides, having the first separation groove disposed therebetween may be disposed to be shifted from each other.

Each of the first electrode, optical active layer, buffer layer and second electrode divided by the separation group forms the power generating part, and each of the first electrodes of the power generating part may be divided in plural by the third separation groove.

A width of the third separation groove may be 10*µ*m to 30*µ*m.

Another embodiment provides a solar cell including: a substrate; a plurality of first electrodes formed on the substrate and separated into a plurality of first separation grooves; a buffer layer and an optical active layer formed on the first electrode and having a through groove exposing the first electrode adjacent thereto; and a plurality of second electrodes formed on the optical active layer, separated into a plurality of second separation grooves, and electrically connected to the first electrode through the through groove, the first electrode and the second electrode are divided by a plurality of third separation groove formed in a direction intersecting with the first separation groove, the through groove, and the second separation groove.

The first separation groove, the through groove, and the second separation groove may be disposed in the order of the first separation groove, the through groove, and the second separation groove to form one of separation group, and the separation group may be repeatedly disposed at predetermined interval.

The third separation groove may traverse any one of the separation groups and may be connected to the second separation groove of the separation groups that are disposed at both sides based on the traversing separation group.

The third separation groove may include a first horizontal part traversing the first separation group of the continuous first, second and third separation groups among the separation groups and connected to the second separation groove of the second separation group, and a second horizontal part traversing the second separation group and connected to the second separation groove of the first and third separation groups.

The first horizontal part and second horizontal part are alternately disposed along the separation groups and may be disposed to be alternated with each other.

The third separation groove may include a third horizontal part connected to the second separation groove of the two separation groups adjacent to each other, and a fourth horizontal part connected to the first separation groove of the two separation groups.

The third horizontal part and fourth horizontal part are alternately disposed along the separation groups and may be disposed to be alternated with each other.

The third horizontal part disposed at both sides, having the second separation groove disposed therebetween may be disposed on the same line, and the fourth horizontal part disposed at both sides, having the first separation groove disposed therebetween may be disposed on the same line.

Each of the first electrode, optical active layer, buffer layer and second electrode divided by the separation group forms the power generating part, and the power generating part may include a plurality of small power generating part divided by the third separation groove.

At least one of the first electrode and the second electrode may be formed of a plurality of small electrode divided in the same size.

A width of the third separation groove may be 10*µ*m to 30*µ*m.

According to an embodiment of the invention, a solar cell can therefore minimize efficiency loss, even though the pattern is defective.

At least some of the above and other features of the invention are set out in the claims.

### BRIEF DESCRIPTION OF THE DRAWINGS

FIG. 1 is a schematic layout view of a solar cell according to an embodiment of the invention.
FIG. 2 is a cross-sectional view taken along line II-II of FIG. 1.
FIG. 3 is a schematic layout view of a solar cell according to an embodiment of the invention.
FIG. 4 is a cross-sectional view taken along line IV-IV of FIG. 3.
FIG. 5 and FIG. 6 are schematic layout views showing a flow of current in first electrode and second electrode of the solar cell shown in FIG. 3.
FIG. 7 is a layout view of a solar cell according to another embodiment of the invention.
FIG. 8 and FIG. 9 are schematic layout views showing a flow of current in first electrode and second electrode of the solar cell shown in FIG. 7.
FIG. 10 is a layout view of a solar cell according to another embodiment of the invention.
FIG. 11 is a schematic layout view showing a power generating part forming the solar cell of FIG. 10.
FIG. 12 is schematic layout view showing a flow of current in first electrode and second electrode of the solar cell shown in FIG. 10.
FIG. 13 is a layout view of a solar cell according to another embodiment of the invention.
FIG. 14 is schematic layout view showing a flow of current in first electrode and second electrode of the solar cell shown in FIG. 13.
FIG. 15 is schematic layout view showing a flow of current in first electrode and second electrode of a solar cell according to another embodiment of the invention.

### DETAILED DESCRIPTION

Hereinafter, embodiments of the inventions will be described in detail with reference to the accompanying drawings. However, the present invention may be modified in various different ways and is not limited to the embodiments provided in the present description.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present.

Hereinafter, a solar cell will be described in detail with reference to the accompanying drawings.

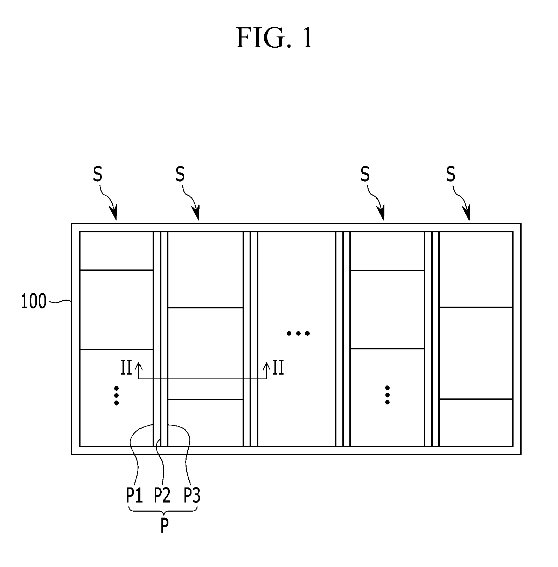

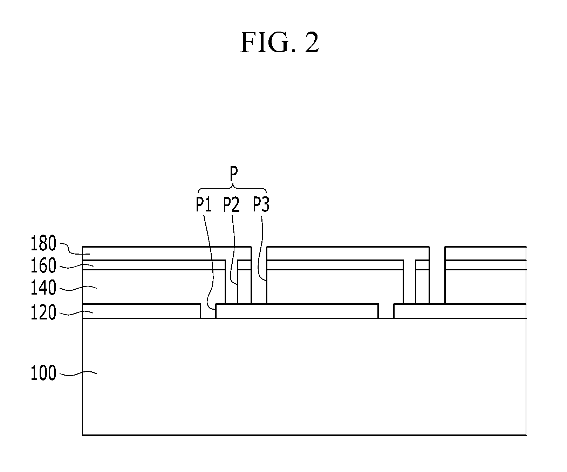

FIG. 1 is a schematic layout view of a solar cell according to an embodiment of the invention and FIG. 2 is a cross-sectional view taken along line II-II of FIG. 1.

As shown in FIG. 1 and FIG. 2, a substrate 100 of a solar cell according to thisembodiment is provided with a plurality of first electrodes 120 formed thereon. The first electrodes 120 are separated into portions by first separation grooves P1 that are formed at regular intervals. In this embodiment, a width of the first separation groove may be from about 20*µ*m to 100*µ*m.

The substrate 100 may be a transparent insulating glass substrate such as a soda-lime glass.

In this embodiment, the first electrode 120 is formed from a metal having an excellent electric conductivity and being between the substrate and a material forming an optical active layer 140. Further, the first electrode 120 may be heat-resistant and provide an excellent interface bonding between the first electrode and the substrate 100. For example, the first electrode 120 may be made from molybdenum (Mo).

The optical active layer 140 and a buffer layer 160 are formed on the first electrode 120. The optical active layer 140 and the buffer layer 160 are in contact with the substrate while covering the first separation groove P1.

The optical active layer 140, which is a copper indium selenide (CIS)-based semiconductor of a P type, may contain selenium (Se) or sulfur (S). For example, as I-III-VI based semiconductor compound, the optical active layer 140 may be Cu(In₁₋ₓ,Gaₓ)(Se₁₋ₓ,Sₓ) and a compound semiconductor having a composition of 0≤x≤1. The optical active layer 140 may be a single phase such that a composition in the compound semiconductor is substantially uniform. For example, the optical active layer 140 may be made from CuInSe₂, CuInS₂, Cu(In,Ga)Se₂, (Ag,Cu)(In,Ga)Se₂, (Ag,Cu)(In,Ga)(Se,S)₂, Cu(In,Ga)(Se,S)₂ or Cu(In,Ga)S₂.

The optical active layer 140 may include sodium (Na), which is diffused from the substrate 100.

The buffer layer 160, which is an n-type semiconductor material having a high light transmittance, serves to alleviate the energy-gap difference between the optical active layer 140 and the second electrode 180. The buffer layer 160, which is the n-type semiconductor material having the high light transmittance, for example, may be formed of cadmium (CdS), zinc sulfide (ZnS) or zinc indium (Ins).

The buffer layer 160 and the optical active layer 140 include a through groove P2 exposing the first electrode 120. In this embodiment, the through groove P2 exposes the first electrode 120 adjacent thereto. The through groove P2 is line-shaped and extends alongside the first separation groove P1, and a width thereof may be from about 20*µ*m to 100*µ*m.

The second electrode 180 divided by the second separation groove P3 is formed on the buffer layer 160.

The second electrode 180 may be made of a material, for example, indium tin oxide(ITO), indium zinc oxide(IZO) and zinc oxide (Zno) having high light transmittance and the excellent electric conductivity and may be formed of a single layer or a multi-layer. The light transmittance of the second electrode 180 may be 80% or more. Further, in this embodiment, the ZnO layer is doped with a conductivity-type impurity such as aluminum (Al) or boron (B), such that it has low resistance value.

When the second electrode 180 is formed as a multi-layer structure, the ITO layer having an excellent electro-optical characteristic may be stacked on the ZnO layer, or a n-type ZnO layer that is doped with a conductivity impurity to have low resistance may be stacked on an i-type ZnO layer that is not doped with the conductivity impurity.

The second electrode 180, which is the n-type semiconductor, forms a pn junction with the optical active layer 140 which is the p-type semiconductor.

Each of the second electrodes 180 is electrically connected by contacting the first electrode 120 adjacent thereto through the through groove P2.

The second separation groove P3 dividing the second electrode 180 and exposing the first electrode 120 is line-shape and extends alongside the first separation groove P1, and a width of the second separation groove P3 may be about 20*µ*m to 100*µ*m.

The first separation groove P1, the through groove P2, and the second separation groove P3 traverse the substrate and are disposed in the order of the first separation groove P1, the through groove P2, and the second separation groove P3 to provide for one separation group which is spaced from other groups. The solar cell includes a power generating part (S) divided by the separation group.

Each of the power generating parts (S) includes the first electrode 120, the optical active layer 140, the buffer layer 160, and the second electrode 180, and the first electrode 120 and second electrode 180 of the two power generating parts adjacent to each other are electrically connected to each other through the through groove P2.

In this embodiment, each of the power generating parts is divided by a plurality of third separation grooves P4 which are formed on the second electrode, the buffer layer, the optical active layer, and the first electrode to expose the substrate. A width of the third separation groove P4 may be 30*µ*m or less, or in one embodiment, between about 10*µ*m to about 30*µ*m.

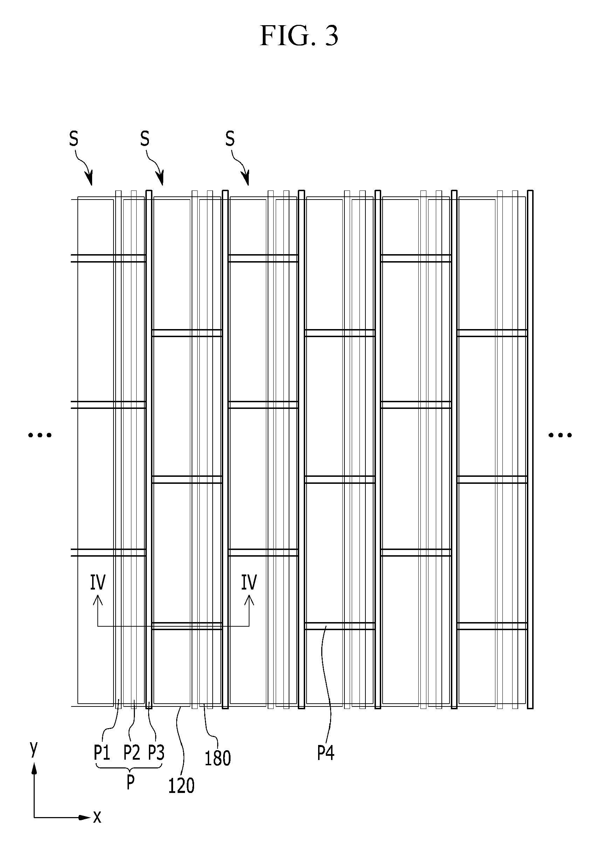

The plurality of third separation grooves P4 may be formed in various orientations that are described in detail with reference to FIG. 3 to FIG. 13.

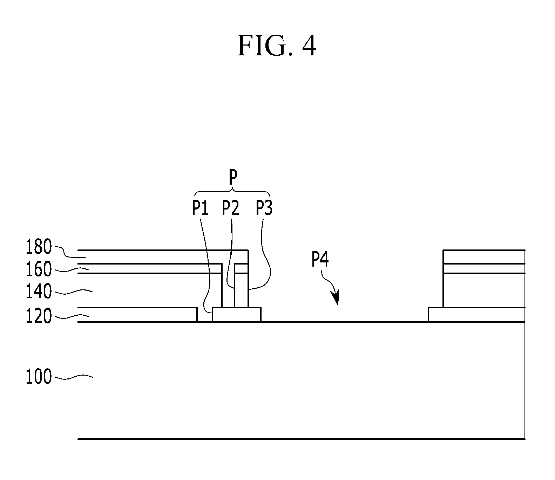

FIG. 3 is a schematic layout view of a solar cell according to an embodiment of the invention, FIG. 4 is a cross-sectional view taken along line IV-IV of FIG. 3, and FIG. 5 and FIG. 6 are schematic layout views showing a flow of current in first electrode and second electrode of the solar cell shown in FIG. 3.

The third separation groove P4 of FIG. 3 and FIG. 4 is connected to the second separation groove P3 by traversing the first separation groove P1 and the through groove P2 of any one of the separation groups P, and is connected to the second separation groove P3 of the separation group P adjacent thereto. In other words, the third separation groove P4 is located between two adjacent second separation grooves P3 and is connected to the two second separation grooves P3.

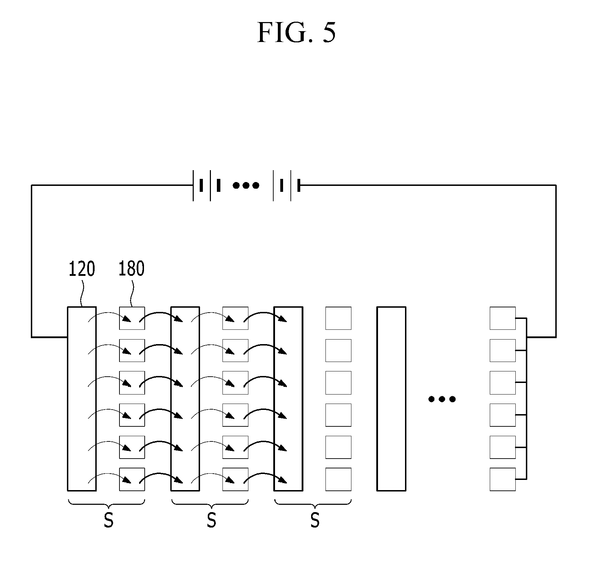

Accordingly, each of the power generating parts includes the plurality of second electrodes 180 which are divided by the single first electrode 120 and the plurality of third separation grooves P4 as shown in FIG. 3 and FIG. 5.

With continued reference to FIG. 3, the third separation grooves P4 that are located between adjacent second separation grooves P3 are offset from each other. Therefore, since the third separation grooves P4 continuous in an X-axis direction are not oriented or located on the same line (i.e., they are not collinear), the third separation grooves P4 adjacent to one another in the X-axis direction are not connected to each other.

When forming the third separation groove P4 according to the this embodiment, it is possible to minimize the degradation in generating efficiency even if the second separation groove P3 and through groove P2 are not separated from each other, such that a short-circuit is generated in the portion which is not separated.

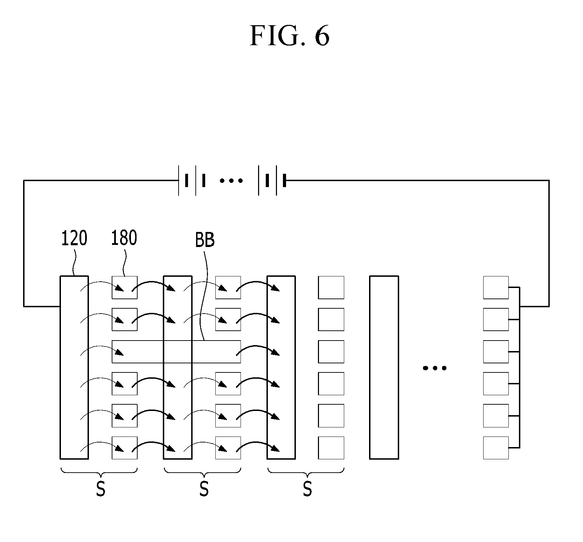

This will be described below with reference to FIG. 6.

FIG. 6 shows a case in which a portion of the second electrode of the adjacent power generating part is short-circuited BB.

Each of the power generating parts according to the related art includes a single second electrode. Accordingly, the whole second electrode of the two power generating parts adjacent to each other may be short-circuited even though a defect is generated in only a portion rather than the whole second separation groove P3, such that a leakage current is generated in the whole second electrode forming the single power generating part. As a result, the current loss may be greater.

However, when forming a third separation groove P4 according to an embodiment of the invention the single power generating part includes the plurality of second electrodes. Therefore, even if a portion of the second separation groove P3 is defective, only the portion of the second electrode positioned at the portion that is defective is short-circuited. Therefore, an area of the second electrode to be short-circuited is decreased compared to in the related art where the entire second electrode forming the single power generating part may be short-circuited. As a result, the leakage current caused by the short-circuit in a power generating part according to an embodiment of the present invention is reduced. The leakage current may have an effect on the generating efficiency, but in such an embodiment, it is possible to minimize an influence of the leakage current from the generating efficiency by minimizing the leakage current.

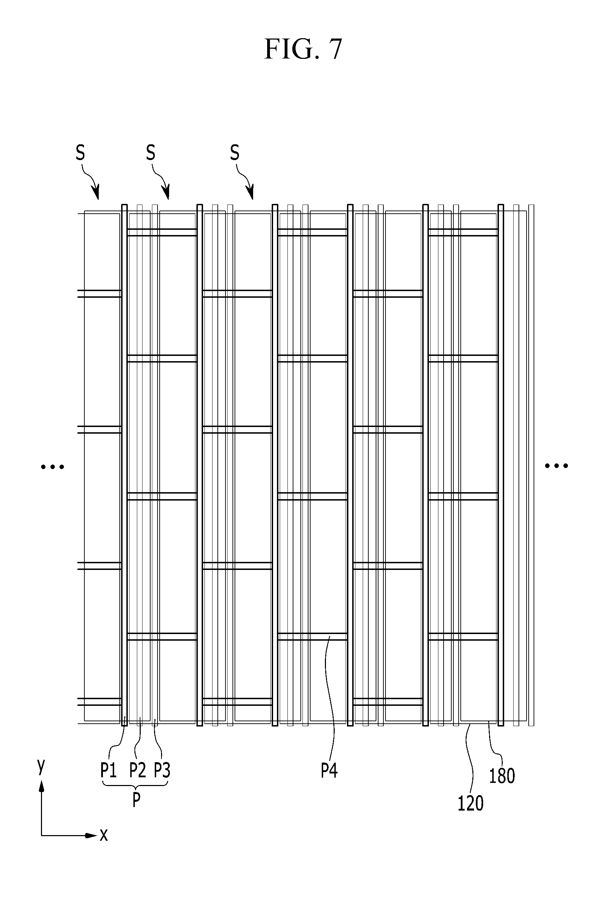

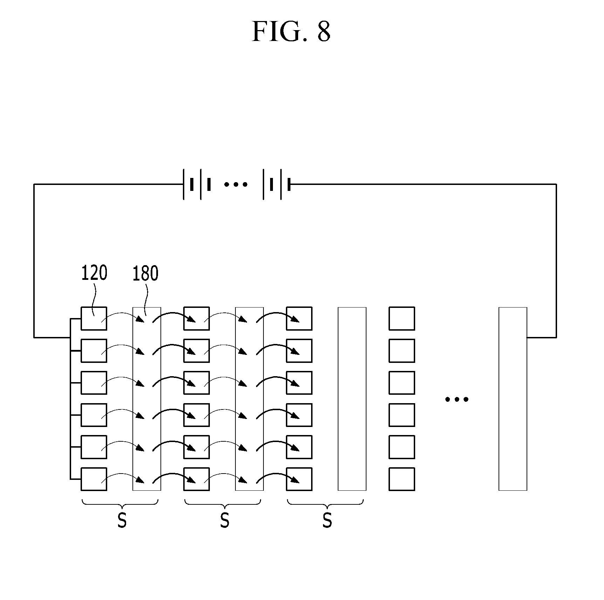

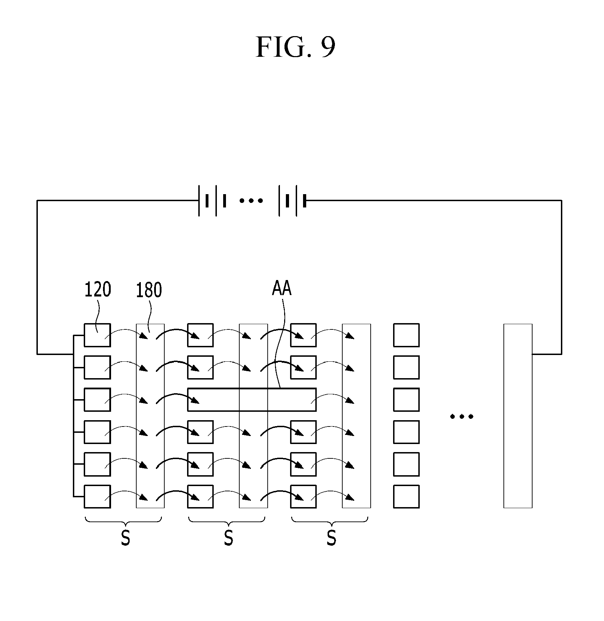

FIG. 7 is a layout view of a solar cell according to another embodiment, and FIG. 8 and FIG. 9 are schematic layout views showing a flow of current in first electrode and second electrode of the solar cell shown in FIG. 7.

As shown in FIG. 7, the third separation groove P4 is connected to the first separation groove P1 by traversing the through groove P2 and the second separation groove P3 of any one of the separation groups P, and is connected to the first separation groove P1 of the separation group P adjacent thereto. In other words, the third separation groove P4 is located between the two first separation grooves P3 adjacent to each other and is connected to the two first separation grooves P1.

Therefore, each of the power generating parts includes the plurality of first electrodes 120 and the single second electrode 170 which are divided by the plurality of third separation grooves P4 as shown in FIG. 7 and FIG. 8.

Again, referring to FIG. 7, the third separation grooves P4 that are located at both sides based on the first separation groove P1 are offset from each other. Therefore, since the third separation grooves P4 oriented in the X-axis direction are not located on the same line, the third separation grooves P4 adjacent in the X-axis direction are not connected to each other.

When forming the third separation groove P4 according to this embodiment, it is possible to minimize the degradation in generating efficiency even if the first separation groove P1 and through groove P2 are not separated from each other, such that a short-circuit is generated in the portion which is not separated.

This will be described below with reference to FIG. 9.

FIG. 9 shows a case in which a portion of the first electrode of the adjacent power generating part is short-circuited AA.

According to some related-art products, each of the power generating parts includes a single first electrode, wherein the whole first electrode of the two power generating parts adjacent to each other is short-circuited even though a defect may be generated in only a portion rather than the whole second separation groove P3 adjacent thereto, such that a leakage current is generated in the whole first electrode forming the single power generating part. As a result, the current loss may be greater.

However, when forming the third separation groove P4 according to this embodiment, the single power generating part includes a plurality of first electrodes. Therefore, even though the portion of the first separation groove P3 is defective, only the portion of the first electrode positioned at the portion that is defective is short-circuited. Therefore, an area of the first electrode to be short-circuited is decreased compared to in the related art where the whole first electrode forming the single power generating part may be short-circuited. As a result, the leakage current caused by the short-circuit is reduced. The leakage current may have an effect on the generating efficiency, but in the exemplary embodiment, it is possible to minimize an influence of the leakage current from the generating efficiency by minimizing the leakage current.

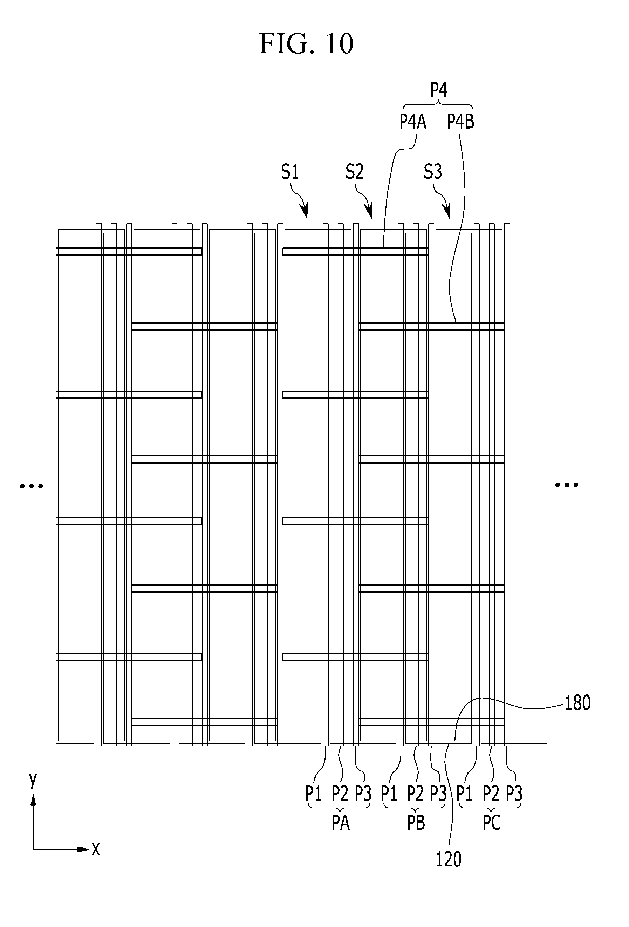

Although this embodiment has been described with reference to the case in which the first electrode or second electrode is divided in plural, the first electrode and second electrode may be divided as shown in FIG. 10 to FIG. 15.

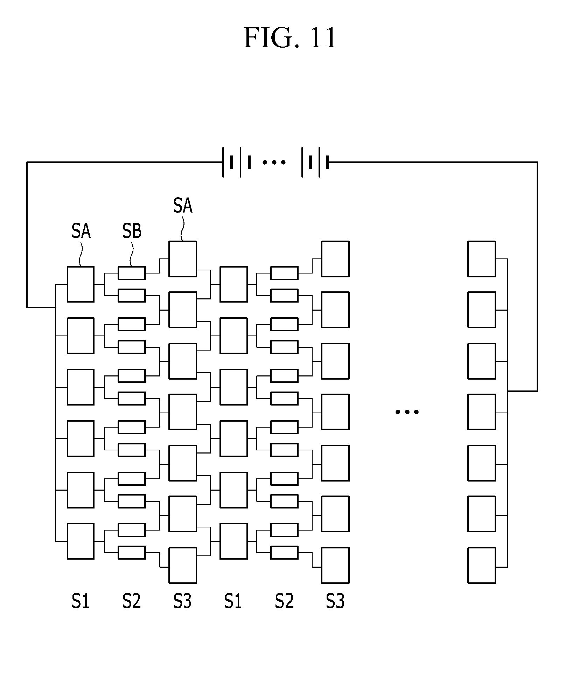

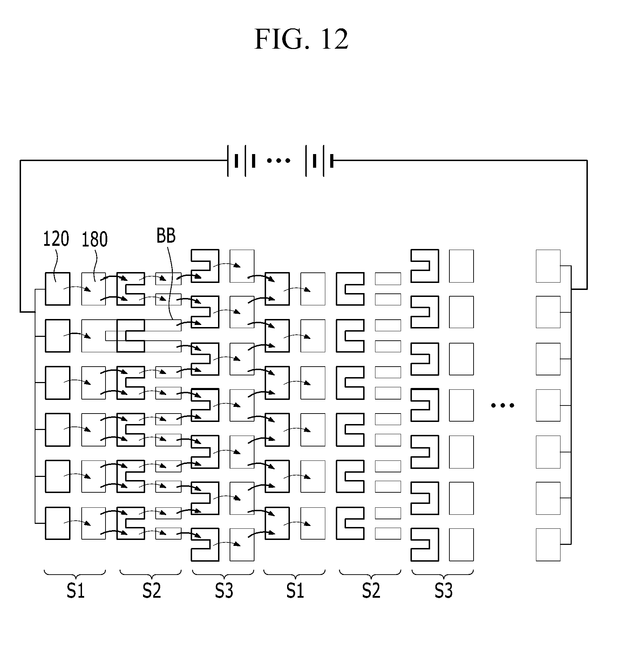

FIG. 10 is a layout view of a solar cell according to another embodiment of the invention, FIG. 11 is a schematic layout view showing a power generating part forming the solar cell of FIG. 10, and FIG. 12 is schematic layout view showing a flow of current in first electrode and second electrode of the solar cell shown in FIG. 10.

As shown in Fig. 10, the third separating groove P4 traverses two second electrodes 180 adjacent to each other in the X-axis direction and the third separating grooves P4 adjacent to each other in a Y-axis direction are offset from each other by the width of the second electrode. Therefore, the third separating groove P4 traverses any one of separation groups and is connected to the second separation groove P3 of the separation groups that are located at both sides based on the traversing single separation group.

The third separating groove P4 includes the first horizontal part P4A traversing the first separation group PA of the continuous first separation group PA, second separation group PB and third separation group PC among the separation groups and connected to the second separation groove P3 of the second separation group PB, and the second horizontal part P4B traversing the second separation group PB and connected to the second separation groove P3 of the first separation group PA and third separation group PC.

Therefore, the first power generating part S1 is divided by the first horizontal parts P4A disposed at predetermined intervals, the second power generating part S2 is divided by the first horizontal parts P4A and second horizontal parts P4B alternately disposed at predetermined intervals, and the third power generating part S3 is divided by the second horizontal parts P4B disposed at predetermined intervals, among the power generating parts that are separated by the first to third separation groups.

Among the power generating parts divided by the three separation groups, when the first horizontal parts P4A and second horizontal parts P4B are formed so as to traverse the two power generating parts, the first horizontal parts P4A and second horizontal parts P4B are offset from each other by the width of the second electrode 180. Therefore, each of the first horizontal parts P4A and second horizontal parts P4B oriented in the X-axis direction are located on the same line, but the first horizontal part P4A and second horizontal part P4B are not located on the same line, such that the third separation grooves P4 adjacent in the X-axis direction are not connected to each other.

As shown in FIG. 10, when the third separation grooves P4 having the first horizontal part P4A and second horizontal part P4B are formed, both of the first electrode 120 and second electrode 180 are divided, such that each of the power generating parts is divided into a plurality of small power generating parts as shown in FIG. 11.

In this embodiment, the first electrode 120 and second electrode 180 may have a shape and a size changed according to the positions of the first horizontal part P4A and second horizontal part P4B, when the first electrode 120 and second electrode 180 are formed as shown in FIG. 10, the first power generating part S1 and the third power generating part S3 are divided into a plurality of first small power generating parts SA, and the second power generating part S2 is divided into a second small power generating part SB having a smaller size than the first small power generating part SA as shown in FIG. 11.

FIG. 10 shows a case in which the third separation grooves P4 traverse two power generating parts among the continuous three power generating parts S1 to S3 and have the first horizontal part P4A and second horizontal part P4B, wherein the first and second horizontal parts arranged in the Y-axis direction along the separation group are offset from each other by the width of the second electrode. In other words, each of the third separation grooves includes a third horizontal part connected to the second separation groove of two adjacent separation groups, and a fourth horizontal part connected to the first separation groove of the two separation groups. Further, the third separation grooves P4 may be formed with respect to the four or more continuous power generation parts, and the three third separation grooves P4 continuous in the X-axis direction are colinear. In this embodiment, so as not to be connected to each other, the horizontal parts adjacent to one another in the Y-axis direction along the separation groups may be offset from one another.

As shown in FIG. 10, when the third separation groove P4 is formed so as to have the first horizontal part and second horizontal part, it is possible to minimize the degradation in generating efficiency even if a portion of the first separation groove P1 or the second separation groove P3 is defective to short-circuit the first electrode or second electrode adjacent thereto.

In other words, as shown in FIG. 12, even though the first electrode 120 or the second electrode 180 is short-circuited, the first electrode or second electrode connected to the portion that is short-circuited BB is made to have the area smaller than the first electrode or second electrode that is formed on the whole power generating part, such that the leakage current may be reduced, as compared to the related art. Therefore, it is possible to minimize an influence of the leakage current on the generating efficiency.

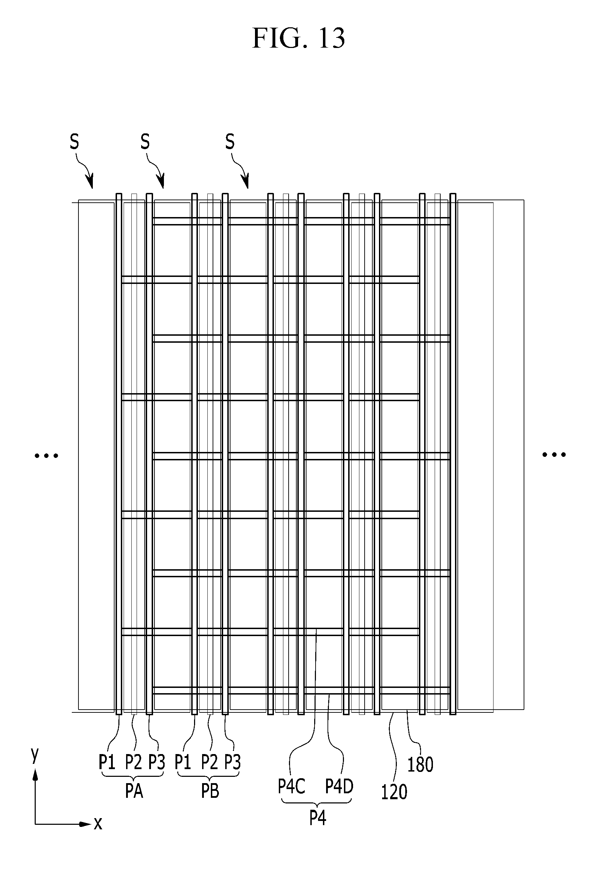

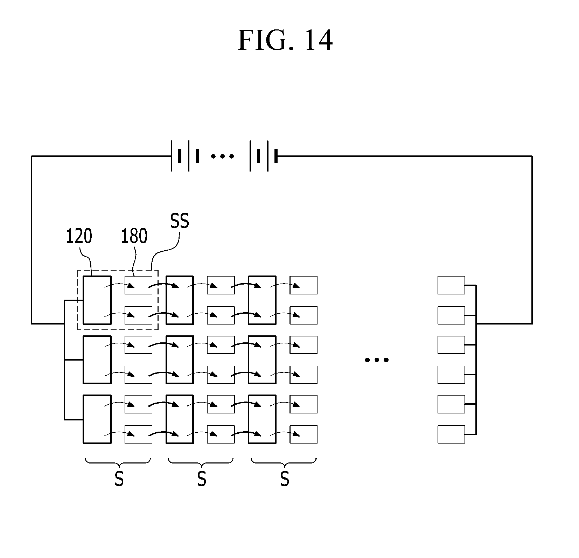

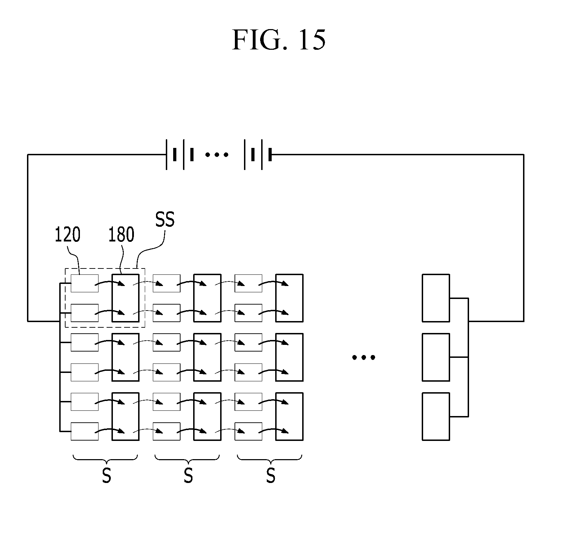

FIG. 13 is a layout view of a solar cell according to another embodiment of the invention, FIG. 14 is schematic layout view showing a flow of current in first electrode and second electrode of the solar cell shown in FIG. 13, and FIG. 15 is schematic layout view showing a flow of current in first electrode and second electrode of a solar cell according to another embodiment.

As shown in FIG. 13, the third separation groove P4 includes a third horizontal part P4C that connects the first separation groove P1 of the two separate groups PA and PB adjacent to each other and a fourth horizontal part P4D that connects the second separation groove P3 thereof, and the third horizontal part P4C and fourth horizontal part P4D are repeatedly located at predetermined intervals in the Y-axis direction along the separation group.

The third horizontal part P4C and fourth horizontal part P4D of the third separation groove P4 are offset from each other in the Y-axis direction, and the third horizontal parts P4C and fourth horizontal parts P4D oriented in the X-axis direction are located on the same line.

When the third separation groove P4 is formed so as to have the third horizontal part P4C and fourth horizontal part P4D, the plurality of first electrodes 120 and second electrodes 180 are formed as shown in FIG. 14. Therefore, the single power generating part S includes the plurality of small power generating parts SS, and each of the small power generating parts SS includes the single first electrode 120 and the two second electrodes 180. On the other hand, as shown in FIG. 15, each of the small power generating parts SS may include the two first electrodes 120 and the signal second electrode 180.

As shown in FIG. 10 to FIG. 15, when the third separation groove P4 is formed so as to have the plurality of horizontal parts that are offset from each other, the first electrode 120 and the second electrode 180 are divided so that the single power generating part includes the plurality of small power generating parts, such that it is possible to minimize an amount of the leakage current generated due to the short-circuit even though the first electrode 120 or the second electrode 180 is short-circuited.

While this disclosure has been described in connection with what is presently considered to be practical embodiment of the invention, it is to be understood that the invention is not limited to the disclosed embodiments, but, on the contrary, is intended to cover various modifications and equivalent arrangements included within the scope of the appended claims.

## Claims

1. A solar cell comprising:
a substrate;
a plurality of first electrodes located on the substrate and separated by a plurality of first separation grooves extending in a first direction;
a buffer layer and an optical active layer located on each of the first electrodes and having a through groove exposing a first one of the first electrodes;
a plurality of second electrodes located on the optical active layer and separated from each other by one of a plurality of second separation grooves, one of the second electrodes being electrically connected to the first electrode via the through groove; and
a plurality of third separation grooves, each extending in a second direction intersecting the first direction and extending between adjacent ones of the said second separation grooves.

2. A solar cell according to claim 1, wherein the second separation grooves divide the buffer layer, the optical active layer, and the second electrodes into separation groups.

3. A solar cell according to claim 1 or 2, wherein each of the third separation grooves is connected to adjacent ones of the second separation grooves.

4. A solar cell according to claim 1 or 2, wherein each of the third separation grooves is connected to adjacent ones of the first separation grooves.

5. A solar cell according to claim 3 or 4, wherein each of the third separation grooves is offset from an adjacent one of the third separation grooves in the first direction.

6. A solar cell according to claim 5, wherein: each of separation groups forms a power generating part; and
adjacent ones of the second electrodes of each power generating part are separated by one of the third separation grooves.

7. A solar cell according to claim 6, wherein each power generating part comprises a plurality of smaller power generating parts defined by the third separation groove.

8. A solar cell according to claim 7, wherein at least one of the first electrode and the second electrode comprises a plurality of small electrodes of the same size.

9. A solar cell according to any preceding claim, wherein a width of each of the third separation grooves is from 10*µ*m to 30*µ*m.

10. A solar cell according to claim 2 or any claim dependent upon claim 2, wherein each of the third separations grooves comprises:
a first part traversing a first one of the separation groups and connected to the second separation groove of a second one of the separation groups adjacent to the first one of the separation groups; and
a second part traversing the second one of the separation groups and connected to the second separation groove of the first one of the separation groups and the second separation groove of a third one of the separation groups.

11. A solar cell according to claim 10, wherein the first parts and second parts are arranged alternately in the first direction.

12. A solar cell according to claim 2 or one of claims 3 to 9 when dependent upon claim 2, wherein each of the third separation grooves traverses one of the separation groups and is connected to one of the second separation grooves of adjacent ones of the separation groups.

13. A solar cell according to claim 12, wherein each of the third separation grooves includes a third part connected to the second separation groove of two adjacent separation groups, and a fourth part connected to the first separation groove of the two separation groups.

14. A solar cell according toclaim 13, wherein the third part and fourth part are arranged alternately in the first direction.

15. A solar cell according to claim 14, wherein each third part has adjacent ones of the second separation grooves located therebetween and is colinear with an adjacent third part, and wherein each fourth part has adjacent ones of the first separation grooves located therebetween and is colinear with an adjacent fourth part.
